# EUROPEAN PATENT APPLICATION

(11) **EP 4 470 730 A1**
(43) Date of publication of application: **04.12.2024**
(21) Application number: 22924158.3
(22) Date of filing: 20.12.2022
(51) Int. Cl.: B25J 9/22, G05B 19/4069, G05B 19/42

(54) **OPERATION PATH GENERATION DEVICE, METHOD, AND PROGRAM**

(30) Priority: 28.01.2022 JP 2022012154
(71) Applicant: OMRON Corporation, Kyoto 600-8530 (JP)
(72) Inventor: ABE, Masayoshi, Kyoto-shi, Kyoto 600-8530 (JP); KAWAKAMI, Shinji, Kyoto-shi, Kyoto 600-8530 (JP); KANAI, Akinobu, Kyoto-shi, Kyoto 600-8530 (JP); SAITOH, Yumi, Kyoto-shi, Kyoto 600-8530 (JP)
(74) Representative: SONN Patentanwälte GmbH & Co KG
(86) International application number: PCT/JP2022/046970
(87) International publication number: WO 2023/145309

(57) **Abstract**

The present invention generates, from among paths that exist for a task to assemble target objects together, an operation path that can be executed at high speed without a probing operation.

An acquisition section 32, for an operation to assemble a main target object 90A gripped by a gripping section of a robot 42 together with an auxiliary target object 90B that is an assembly target, acquires a start position and orientation, and an end position and orientation, of the gripping section relative to the main target object 90A, and acquires environment information. Based on the acquired information, a simulation section 34 performs a simulation of a transition of contact states between the main target object 90A and the auxiliary target object 90B, from a contact state until there is a non-contact state. Based on the acquired information and on the simulated transition of contact states, a generation section 36 generates an operation path of the robot to reach a goal state from an initial state until reaching one or another contact state included in the transition of contact states, along a transition of contact states including the one or the other of the contact states.

## Description

### Technical Field

The present disclosure relates to an operation path generation device, an operation path generation method, and an operation path generation program.

### Background Art

Hitherto technology has been proposed for generating an operation path of a robot to execute a task to assemble a main target object gripped by a robot together with an auxiliary target object that is an assembly target. For example, there is a proposal for a multi-finger hand to reliably make a high speed insertion in an assembly process having a small clearance between bodies. Such a multi-finger hand features six degrees of freedom of back drivability and object orientation observability, and in order to achieve high speed insertion of small bodies together with each other, implements both impact reduction and position error compensation when two bodies make contact with each other (International Publication (WO) No. 2020/194393).

Moreover, for example, there is a proposal for a path output method that automatically generates an operation path of a robot from a start state to a goal state. This path output method is a method that employs a computation device including an external interface, a storage section, and a computation section to output a path for a robot with plural moveable axes to transport a target object from a first position to a second position. The computation section acquires the first position and the second position using an external interface, and acquires transport conditions for when the robot transports the target object from the first position to the second position. A path is generated that satisfies the transport conditions across all paths that are paths for the robot to transport the target object from the first position to the second position (Japanese Patent No. 6860863).

### SUMMARY OF INVENTION

### Technical Problem

However, in the technology described in Patent Document 1, a person generates the operation path, and so there is a need for a person with specialist knowledge when teaching an assembly task to a robot. Moreover, there is a problem with cases in which an operation path is built in which so-called probing operations occur, so as to reach a goal assembled state while adjusting positional errors of the target object, in that execution of a task is slow due to the probing time being long and variable, meaning that the time required for such a task is unable to be estimated. Moreover, because paths are generated to avoid contact with the peripheral environment in the technology of Patent Document 2, the technology is not applicable to generate an operation path of a task having the objective of assembling target objects together.

In consideration of the above circumstances, an object of the present disclosure is to generate, from among existing paths for a task of assembling target objects together, an operation path that can be executed at high speed without a probing operation.

### Solution to Problem

In order to achieve the above object, an operation path generation device according to the present disclosure is configured including an acquisition section, a simulation section, and a generation section. For an operation to assemble a main target object gripped by a gripping section of a robot together with an auxiliary target object that is an assembly target, the acquisition section acquires a start position and orientation, and an end position and orientation, of the gripping section relative to the main target object, and acquires shape information of a task environment containing the main target object and the auxiliary target object. Based on the information acquired by the acquisition section, the simulation section performs a simulation of a transition of contact states between the main target object and the auxiliary target object, from a contact state between the main target object and the auxiliary target object until there is a non-contact state between the main target object and the auxiliary target object. Based on the information acquired by the acquisition section and on the transition of contact states simulated by the simulation section, the generation section generates an operation path of the robot to reach a goal state from an initial state, which is the start position and orientation of the gripping section, until reaching one or another contact state included in the transition of contact states, along a transition of contact states including the one or the other of the contact states.

Moreover, an operation path generation method according to the present disclosure is a method that includes: an acquisition section acquiring, for an operation to assemble a main target object gripped by a gripping section of a robot together with an auxiliary target object that is an assembly target, a start position and orientation, and an end position and orientation, of the gripping section relative to the main target object, and acquiring shape information of a task environment containing the main target object and the auxiliary target object; a simulation section performing a simulation, based on the information acquired by the acquisition section, of a transition of contact states between the main target object and the auxiliary target object, from a contact state between the main target object and the auxiliary target object until there is a non-contact state between the main target object and the auxiliary target object; and a generation section generating, based on the information acquired by the acquisition section and on the transition of contact states simulated by the simulation section, an operation path of the robot to reach a goal state from an initial state, which is the start position and orientation of the gripping section, until reaching one or another contact state included in the transition of contact states, along a transition of contact states including the one or the other of the contact states.

An operation path generation program according to the present disclosure is a program that causes a computer to function as an acquisition section, a simulation section, and a generation section. For an operation to assemble a main target object gripped by a gripping section of a robot together with an auxiliary target object that is an assembly target, the acquisition section acquires a start position and orientation, and an end position and orientation, of the gripping section relative to the main target object, and acquires shape information of a task environment containing the main target object and the auxiliary target object. Based on the information acquired by the acquisition section, the simulation section performs a simulation of a transition of contact states between the main target object and the auxiliary target object, from a contact state between the main target object and the auxiliary target object until there is a non-contact state between the main target object and the auxiliary target object. Based on the information acquired by the acquisition section and on the transition of contact states simulated by the simulation section, the generation section generates an operation path of the robot to reach a goal state from an initial state, which is the start position and orientation of the gripping section, until reaching one or another contact state included in the transition of contact states, along a transition of contact states including the one or the other of the contact states.

The operation path generation device, method, and program according to the present disclosure are able, from among existing paths for a task of assembling target objects together, to generate of an operation path that can be executed at high speed without a probing operation.

### BRIEF DESCRIPTION OF DRAWINGS

Fig. 1 is a schematic configuration diagram of a robot control system 1.
Fig. 2 is a diagram to explain an example of an operation path in a present exemplary embodiment.
Fig. 3 is a diagram illustrating an example of a three-dimensional representation of a configuration space.
Fig. 4 is a block diagram illustrating a hardware configuration of an operation path generation device.
Fig. 5 is a block diagram illustrating an example of a functional configuration of an operation path generation device.
Fig. 6A is a diagram illustrating an example of face contact.
Fig. 6B is a diagram illustrating an example of face contact.
Fig. 6C is a diagram illustrating an example of face contact.
Fig. 7A is a diagram illustrating an example of edge contact.
Fig. 7B is a diagram illustrating an example of edge contact.
Fig. 7C is a diagram illustrating an example of edge contact.
Fig. 7D is a diagram illustrating an example of edge contact.
Fig. 7E is a diagram illustrating an example of edge contact.
Fig. 7F is a diagram illustrating an example of edge contact.
Fig. 8 is a diagram to explain maintain displacement and separation displacement.
Fig. 9 is a diagram illustrating an example of a first presentation screen.
Fig. 10 is a diagram illustrating an example of a second presentation screen.
Fig. 11 is a flowchart illustrating an example of operation path generation processing.
Fig. 12 is a flowchart illustrating an example of branch-tree generation processing.
Fig. 13 is a diagram to explain limits of a maintain range of a contact state.
Fig. 14 is a diagram to explain a specific example of branch-tree generation processing.
Fig. 15 is a diagram to explain a specific example of branch-tree generation processing.
Fig. 16 is a diagram to explain a specific example of branch-tree generation processing.
Fig. 17 is a diagram to explain a branch-tree.
Fig. 18 is a diagram to explain a relationship between a maintain range and a resolution.
Fig. 19 is a diagram to explain a relationship between a maintain range and a resolution.
Fig. 20 is a diagram to explain robot control not considering contact with the environment.
Fig. 21 is a diagram to explain admittance control as an example of an implementation example of a force control system as the target for implementation of the present disclosure.
Fig. 22 is a diagram to explain impedance control as an example of an implementation example of a force control system as the target for implementation of the present disclosure.

### DESCRIPTION OF EMBODIMENTS

Description follows regarding examples of exemplary embodiments of the present disclosure, with reference to the drawings. Note that configuration elements and portions that are the same or equivalent are appended with the same reference numerals in each of the drawings. Moreover, dimensions and proportions in the drawings are exaggerated for ease of explanation, and sometimes differ from actual proportions.

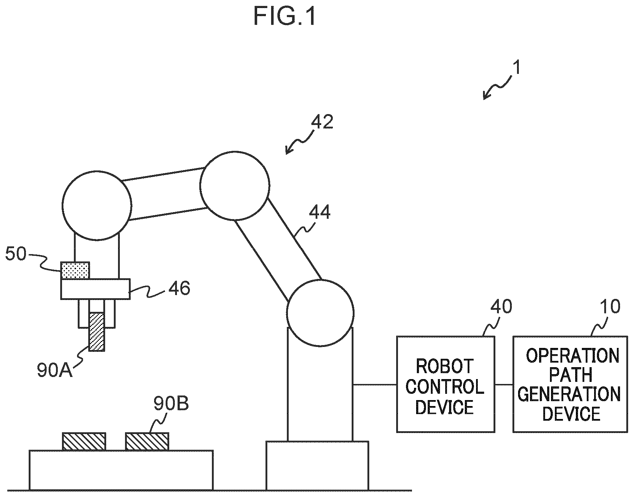

As illustrated in Fig. 1, a robot control system 1 according to the present exemplary embodiment is configured including an operation path generation device 10, a robot control device 40, a robot 42, and a sensor group 50.

The robot 42 includes a robot arm 44 and a hand section 46. The hand section 46 is an example of a "gripping section" of the present disclosure. The robot arm 44 is configured including links, and joints that connect between the links and that also rotate or perform a linear motion extension or contraction under drive from motors. Motors in the robot arm 44 are driven according to command values output from the robot control device 40, and change the rotation angle or the extension/contraction state of the joints. The hand section 46 is accordingly controlled so as to adopt a specified position and specified orientation in three-dimensional space. Note that in the present exemplary embodiment, positions and orientations are expressed using an X axis and a Y axis that are two orthogonal directions in a horizontal plane, a Z axis that is a vertical direction, with rotation about the X axis denoted by ϕ, rotation about the Y axis denoted by θ, and rotation about the Z axis denoted by ψ.

The hand section 46 is provided at a distal end of the robot arm 44 and is a tool capable of gripping a main target object 90A. The hand section 46 may, for example, be a multi-joint multi-finger robot hand, a gripper robot hand, a suction pad, or the like.

The robot 42 may be appropriately configured by a soft robot that performs behaviors to accustom itself to the external environment by joints and links being outpushed by reaction force from contact with the external environment, and may be configured by a soft robot including a hand section 46 with such properties.

The sensor group 50 includes plural types of sensor, and the sensor data acquired by each of the sensors is output as time series data to the robot control device 40. Note that although the sensor group 50 is schematically represented in Fig. 1 as a single block in the vicinity of the hand section 46, each of the sensors contained in the sensor group 50 is actually provided at a respective position corresponding to the type and function of the sensor.

The sensors may be provided as needed according to the task to be performed by the robot 42. However, in the present exemplary embodiment operation of the robot 42 is controlled based on an operation path of a task to assemble a main target object 90A and an auxiliary target object 90B together using contact. This means that the sensor group 50 contains sensors capable of detecting external force during contact between the main target object 90A and the environment, for example force sensors, sensors (pad sensors) capable of measuring deformation amounts of a pad, and the like. Encoders of motors may also be utilized as sensors capable of detecting external force. In such cases a difference between the output value of the motor encoder and a command value to the motor is detected as external force. The sensor group 50 also contains, as other sensors, sensors capable of recognizing relative errors related to the position and orientation of the main target object 90A with respect to the control goal (hereafter referred to as "position and orientation errors"), for example vision sensors, proximity sensors, and the like. Note that pad sensors may also be utilized as sensors capable of recognizing position and orientation errors.

The robot control device 40 generates command values based on the operation path generated by the operation path generation device 10, and outputs the command values to the robot 42.

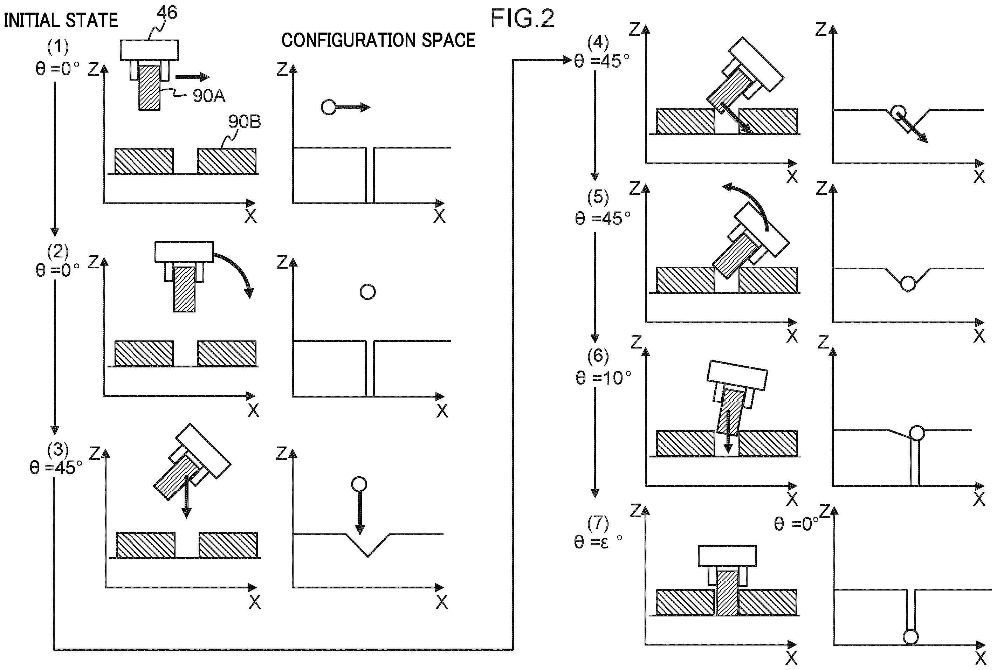

Description follows regarding an example of an operation path of the present exemplary embodiment, with reference to Fig. 2. The example of Fig. 2 is of an operation path for a task to insert a circular rod shaped shaft as the main target object 90A into a hole (insertion position) of a circular cylindrical shaped ring as the auxiliary target object 90B. Fig. 2 illustrates schematic side views illustrating positional relationships between the main target object 90A and the auxiliary target object 90B for each operation, illustrated alongside a configuration space during each operation. In Fig. 2, a circle in configuration space represents coordinates of a position and an orientation of a bottom face right side of the shaft serving as the main target object 90A at a start time for each operation.

First, as an initial state, is a state in which the main target object 90A is gripped by the hand section 46 with a tilt (θ) of 0°, and the main target object 90A and the auxiliary target object 90B are in a non-contact state. Operation (1) is an operation to translate the main target object 90A from the initial state to above the insertion position of the auxiliary target object 90B. Operation (2) is an operation to tilt the main target object 90A at a specific angle (45° in the example of Fig. 2). Operation (3) is an operation to lower the main target object 90A toward the insertion position until there is contact between the main target object 90A and the auxiliary target object 90B. The configuration space of operation (3) shows that the main target object 90A is unable to reach the bottommost portion of the hole of the auxiliary target object 90B due to the main target object 90A being tilted.

Operation (4) is an operation to move the main target object 90A toward the insertion position direction, while maintaining tilt of the main target object 90A and while maintaining contact between the main target object 90A and the auxiliary target object 90B, until another location of the main target object 90A contacts the auxiliary target object 90B. Operation (5) is an operation that uses alignment between the main target object 90A and the auxiliary target object 90B to return a tilt of the main target object 90A to an angle (10° in the example of Fig. 2) enabling the main target object 90A to be lowered along an inner periphery of the insertion position (hole) of the auxiliary target object 90B. Operation (6) is an operation to move the main target object 90A downward along the inner periphery of the insertion position (hole) of the auxiliary target object 90B. Operation (7) is an operation to place the main target object 90A at a goal angle ε° (0° in the example of Fig. 2). The present exemplary embodiment accordingly postulates an operation path that utilizes contact between the main target object 90A and the auxiliary target object 90B, which is one item in the environment.

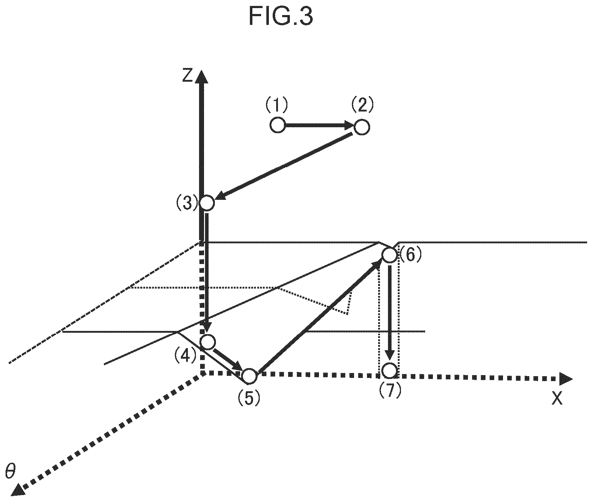

Note that although Fig. 2 illustrates the configuration space represented in two dimensions, the configuration space in Fig. 2 includes an axis of θ in a direction perpendicular to the page. Fig. 3 illustrates an example of a three-dimensional representation of configuration space. In Fig. 3, by a circle in the configuration space represents the coordinates of the position and orientation of the bottom face right side of the shaft serving as the main target object 90A at a start time for each operation (1) to (7) of Fig. 2.

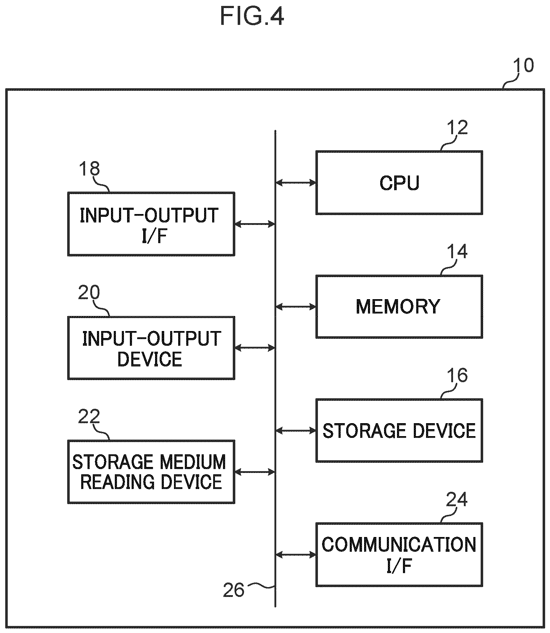

The operation path generation device 10 generates the operation path using a simulation, and outputs the operation path to the robot control device 40. Fig. 4 is a block diagram illustrating a hardware configuration of the operation path generation device 10 according to the present exemplary embodiment. As illustrated in Fig. 4, the operation path generation device 10 includes a central processing unit (CPU) 12, memory 14, a storage device 16, an input-output interface (I/F) 18, an input-output device 20, a storage medium reading device 22, and a communication I/F 24. Each configuration is connected so as to be able to mutually communicate through a bus 26.

An operation path generation program for executing operation path generation processing, described later, is stored in the storage device 16. The CPU 12 is a central processing unit for executing various programs and controlling each configuration. Namely, the CPU 12 reads the program from the storage device 16, and executes the program using the memory 14 as workspace. The CPU 12 controls each configuration and performs various computational processing according to the program stored on the storage device 16.

The memory 14 is configured by random access memory (RAM) and serves as workspace for temporarily storing programs and data. The storage device 16 is configured by a read only memory (ROM), and a hard disk drive (HDD), solid state drive (SSD), or the like, and stores various programs including an operating system and various data.

The input-output I/F 18 is an interface for connecting the operation path generation device 10 and the robot control device 40 together. The operation path generated by the operation path generation device 10 is output to the robot control device 40 through the input-output I/F 18. The input-output device 20 is, for example, an input device such as a keyboard, mouse, or the like to perform various input, and an output device such as a display device such as a display, a printer, or the like for performing output of various information. By adopting a touch panel display as the output device, this may also function as an input device.

The storage medium reading device 22 reads data stored on various storage media such as a compact disc (CD)-ROM, digital versatile disc (DVD)-ROM, Blu-ray disc, universal serial bus (USB) memory, or the like, and writes data to the storage media. The communication I/F 24 is an interface to communicate with other devices, and employs a standard such as, for example, Ethernet (registered trademark), FDDI, or Wi-Fi (registered trademark).

Next, description follows regarding a functional configuration of the operation path generation device 10 according to the present exemplary embodiment.

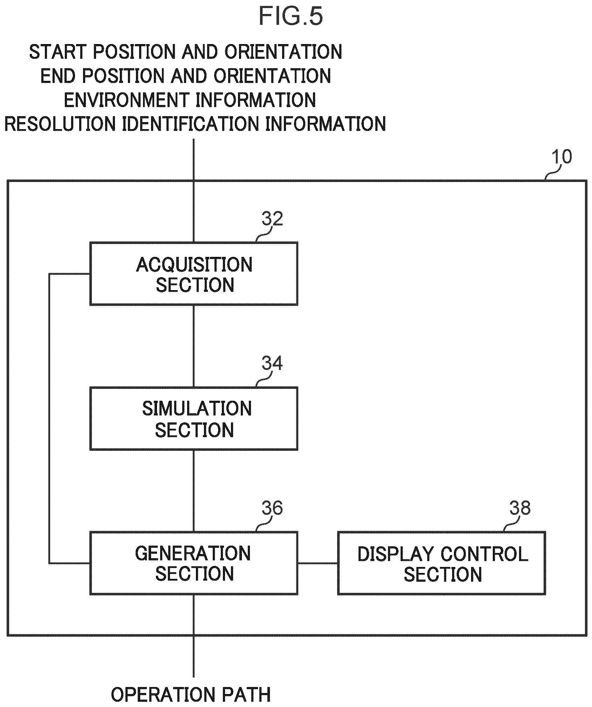

Fig. 5 is a block diagram illustrating an example of a functional configuration of the operation path generation device 10. The operation path generation device 10 is input with relative position and orientation information of the hand section 46 at a start position with respect to the main target object 90A (hereafter referred to as "start position and orientation"), and with relative position and orientation information of the hand section 46 at an end position with respect to the main target object 90A (hereafter referred to as "end position and orientation"). The operation path generation device 10 is also input with environment information indicating a profile and placement of a task environment containing the main target object 90A and the auxiliary target object 90B. The environment information contains, for example, CAD data for both the main target object 90A and the auxiliary target object 90B, a configuration space representing the task environment with obstructions disposed therein, and the like. The operation path generation device 10 is also input with information to identify a resolution of operation of the robot 42 (hereafter referred to as "resolution identification information"). The resolution identification information includes at least one out of a resolution of sensors contained in the sensor group 50 or a control precision of actuators to drive the robot 42.

As illustrated in Fig. 5, the operation path generation device 10 includes, as functional configuration, an acquisition section 32, a simulation section 34, a generation section 36, and a display control section 38. Each functional configuration is implemented by the CPU 12 reading the operation path generation program stored in the storage device 16, and expanding and executing the operation path generation program in the memory 14.

The acquisition section 32 acquires the start position and orientation, the end position and orientation, and the environment information that were input to the operation path generation device 10, and passes these across to the simulation section 34. The acquisition section 32 also acquires the resolution identification information input to the operation path generation device 10 and passes these across to the generation section 36.

Based on the information passed across from the acquisition section 32, the simulation section 34 simulates a transition of contact states between the main target object 90A and the auxiliary target object 90B, from a contact state between the main target object 90A and the auxiliary target object 90B until a non-contact state between the main target object 90A and the auxiliary target object 90B.

Contact states between the main target object 90A and the auxiliary target object 90B will now be defined. A contact state in which a face of the main target object 90A and a face of the auxiliary target object 90B contact each other is called a face contact. Moreover, a contact state in which an edge (or a point) of at least one out of the main target object 90A or the auxiliary target object 90B contacts the other out of the main target object 90A or the auxiliary target object 90B is called an edge (or point) contact. In the following, the "(or point)" in edge (or point) will be omitted, and this will be simply called "edge". Moreover, in the following a face orthogonal to the X axis is called an "X face", a face orthogonal to the Y axis is called a "Y face", and a face orthogonal to the Z axis is called a "Z face". Furthermore, in each of the following drawings, a contact location of face contact is represented by a solid line, and a contact location of edge contact is represented by a black circle.

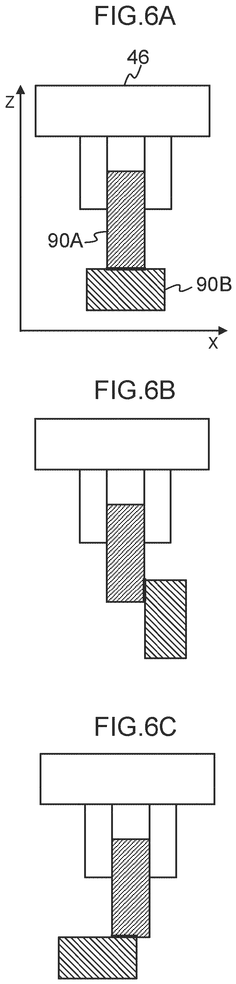

Fig. 6A to Fig. 6C illustrate examples of face contact. In Fig. 6A, the main target object 90A and the auxiliary target object 90B contact each other at a Z face, and in Fig. 6B, the main target object 90A and the auxiliary target object 90B contact each other at an X face. Even with such face contact, Fig. 6A and Fig. 6B are treated as illustrating face contact of different respective contact states when the contact face is different. Moreover, whereas the entire Z face of the main target object 90A contacts the auxiliary target object 90B in Fig. 6A, only part of the Z face is in contact in Fig. 6C. In such cases Fig. 6A and Fig. 6C are treated as illustrating face contact of different respective contact states.

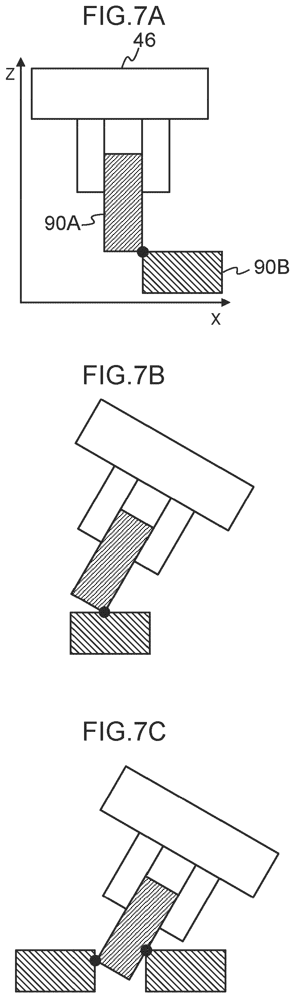

Fig. 7A to Fig. 7F illustrate examples of edge contact. Fig. 7A and Fig. 7B illustrate edge contact in which the main target object 90A and the auxiliary target object 90B contact each other along one edge. Such edge contact in which there is contact at one edge is hereafter referred to as "one-edge contact". In this example, one edge at a lower side Z face right (= right side X face bottom) of the main target object 90A in Fig. 7A is in contact with one edge of an upper side Z face left (= left side X face top) of the auxiliary target object 90B. In Fig. 7B, one edge of the lower side Z face right (= right side X face bottom) of the main target object 90A contacts the upper side Z face of the auxiliary target object 90B. These are treated as one-edge contact of different respective contact states.

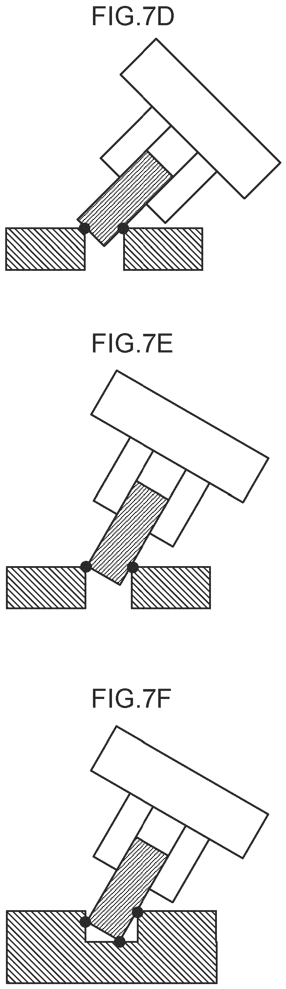

Moreover, Fig. 7C, Fig. 7D, and Fig. 7E illustrate edge contact in which two edges of the main target object 90A and the auxiliary target object 90B contact each other. Such edge contacts in which two edges contact each other are hereafter referred to as "two-edge contacts". In these examples, one edge at the lower side Z face left (= the left side X face bottom) of the main target object 90A in Fig. 7C contacts the right side X face of the auxiliary target object 90B on the left, and one edge at the upper side Z face left (= the left side X face top) of the auxiliary target object 90B on the right contacts the right side X face of the main target object 90A. Moreover, in Fig. 7D, one edge at the upper side Z face right (= the right side X face top) of the auxiliary target object 90B on the left contacts the lower side Z face of the main target object 90A, and one edge at the upper side Z face left (= the left side X face top) of the auxiliary target object 90B on the right contacts the right side X face of the main target object 90A. Moreover, in Fig. 7E, one edge at the lower side Z face left (= the left side X face bottom) of the main target object 90A contacts one edge at the upper side Z face right (= the right side X face top) of the auxiliary target object 90B on the left, and one edge at the upper side Z face left (= the left side X face top) of the auxiliary target object 90B on the right contacts the right side X face of the main target object 90A. In such cases in which at least one location of contacting edge is different, these are treated as being two-edge contacts of different respective contact states. Note that Fig. 7F illustrates an example of three-edge contact in which the main target object 90A and the auxiliary target object 90B are in contact at three edges.

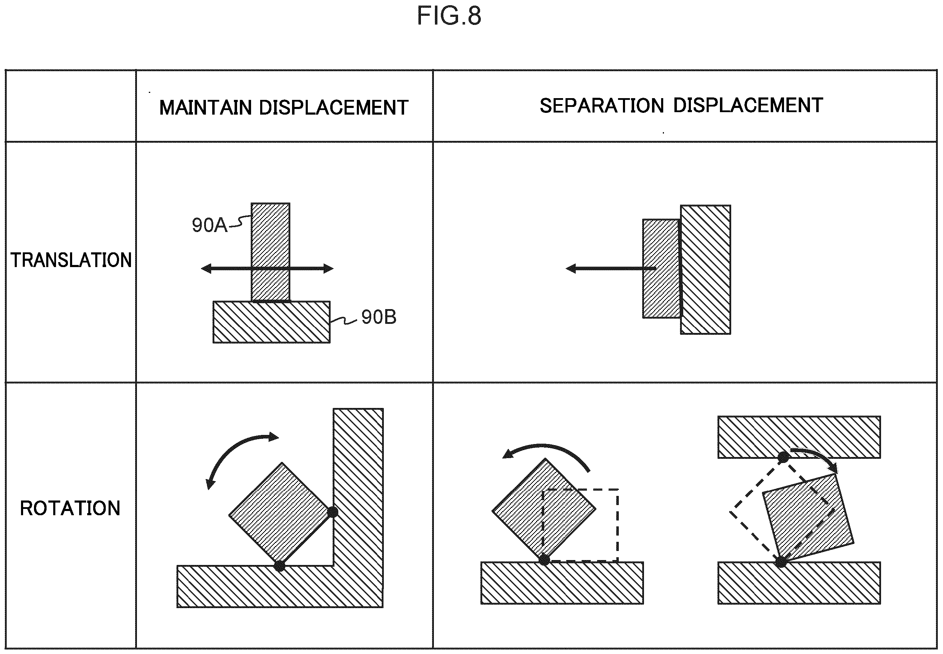

The simulation section 34 is a simulation performed of transitions of contact states starting from the goal state. In the simulation, when the contact state between the main target object 90A and the auxiliary target object 90B reaches a non-movement state (a two-edge contact state to a face contact state) even though force is being applied in a given direction, force continues to be applied but this time in a different direction when this again reaches a non-movement state, force continues to be applied in a different direction from this state, with such operations being performed repeatedly. Maintain displacements and separation displacements as illustrated in Fig. 8 should be considered as displacements of the main target object 90A with respect to the auxiliary target object 90B when searching for such contact state transitions. Maintain displacements are displacements in which the main target object 90A is displaced while maintaining the same contact state. As illustrated in Fig. 8, maintain displacements include cases in which the main target object 90A is translated while face contact is maintained, and include cases in which the main target object 90A is rotated while one-edge contact or two-edge contact is maintained. Separation displacements are displacements in which the main target object 90A is displaced in a direction of increased degrees of freedom of contact state. As illustrated in Fig. 8, separation displacements include translating the main target object 90A in a direction that intersects with a contact face of face contact with the auxiliary target object 90B that is a direction away from the auxiliary target object 90B. Moreover, separation displacements include rotating the main target object 90A to give one-edge contact from face contact or from two-edge contact.

Specifically, the simulation section 34 generates a branch-tree including the goal state as a root node, and including nodes corresponding to the different respective contact states while searching transition of contact states as described above. More specifically, the simulation section 34 performs a simulation from any state out of a two-edge contact, three-edge contact, or face contact state, to simulate whether or not a new contact state is reached at a state immediately after a separation displacement movement has been performed, or by continuing to execute maintain displacement for a direction in which movement of the separation displacement was performed. In cases in which a new contact state has been reached, the simulation section 34 also executes a similar search (generation of a branch-tree) on this contact state for cases in which the new contact state is two-edge contact, three-edge contact, or face contact. The simulation section 34 also records only a one-edge contact state in the branch-tree for cases in which a contact state immediately after movement of a separation displacement is one-edge contact, and a new state reached by continuing to execute maintain displacement for the direction in which the separation displacement movement was performed is a state of no contact at all. For each of the nodes of the branch-tree, the simulation section 34 finds a range that the main target object 90A is able to perform maintain displacement in the contact state corresponding to the respective node (hereafter referred to as a "maintain range"), and associates this range with the node. The simulation section 34 finds the maintain range for each direction of translations directions (X, Y, Z) and rotation directions (ϕ, θ, ψ).

Based on the information acquired by the acquisition section 32 and on the transition of contact states simulated by the simulation section 34, the generation section 36 generates an operation path of the robot to reach the goal state from an initial state, which is the start position and orientation of the main target object 90A, until reaching one or other contact state included in the transition of contact states, along a transition of contact states including the one or other of the contact states. Specifically, the generation section 36 identifies a node in the branch-tree that has been associated with a larger maintain range than the resolution of the operation of the robot 42. The generation section 36 identifies the nearest node from the root node of the branch-tree in cases in which there are plural nodes identified. Then the generation section 36 identifies a transition of contact states in the branch-tree corresponding to from the identified node to the root node, and generates a path of the robot 42 corresponding to the identified transition of contact states. Moreover, the generation section 36 generates a path from a position of the initial state to the contact state corresponding to the identified node that is a path avoiding obstructions in the surroundings. The generation section 36 then passes across to the display control section 38, as an operation path, a path resulting from joining the path from the initial state to the contact state corresponding to the identified node together with the path from the contact state corresponding to the identified node to the goal state. Note that a path is a series of positions and orientations of specific segment (for example a finger) of the hand section 46 of the robot 42.

In cases in which a user recorded position and orientation, described later, has been received and regeneration of the operation path has been instructed from the display control section 38, the generation section 36 regenerates the operation path while reflecting the user recorded position and orientation in the already generated operation path. Details are described later, however basically the user recorded position and orientation is recorded with a corrected position and orientation of the main target object 90A at an identified time on the operation path. The generation section 36 may regenerate the operation path by correcting the already generated operation path so as to pass through the specified position and orientation. Moreover, the generation section 36 may search the branch-tree for a node that has been associated with the contact state corresponding to the user recorded position and orientation, and regenerate the operation path based on a transition of contact states passing through the contact state corresponding to the found node.

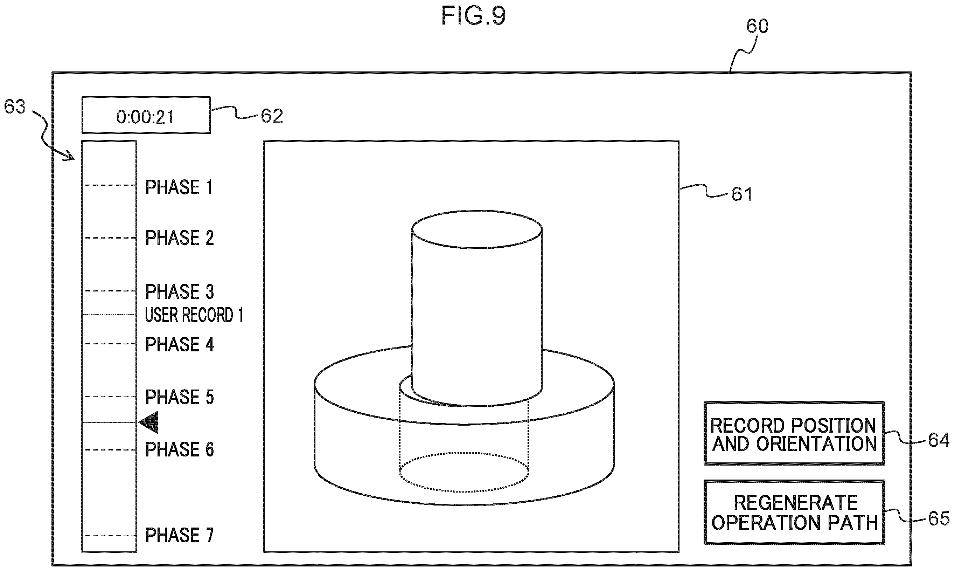

The display control section 38 displays the operation path generated by the generation section 36 on a display device. The display control section 38 displays a first presentation screen 60 on the display device, for example as illustrated in Fig. 9. The example of Fig. 9 includes a three-dimensional view 61 on the first presentation screen 60. In the three-dimensional view 61, the three-dimensional positions (X, Y, Z) and orientations (ϕ, θ, ψ) of the main target object 90A and the auxiliary target object 90B from the initial state to the goal state are previewed in a three-dimensional animation. In addition to the main target object 90A and the auxiliary target object 90B, a three-dimensional image of the environment may also be displayed together therewith. Moreover, in the three-dimensional view 61, the positions and orientations of the main target object 90A and the auxiliary target object 90B may be configured so as to be movable using a mouse, like in three-dimensional CAD software.

Moreover, the first presentation screen 60 includes a time display 62 displayed with a replay time of the animation being displayed in the three-dimensional view 61. Namely, the time display 62 is displayed with a time associated with the frame being displayed on the three-dimensional view 61 from among the times associated with respective frames of the animation being displayed on the three-dimensional view 61. Moreover, a freely selected time may be input to the time display 62, so as to display a frame corresponding to this time on the three-dimensional view 61.

The first presentation screen 60 also includes a phase display 63. The phase display 63 includes a single axis display such as a strip shaped display or the like to indicate elapsed time from start to end of operation indicated by the operation path, with first marks (dashed lines in the phase display 63 of Fig. 9) displayed at positions corresponding to times on the operation path when a contact state between the main target object 90A and the auxiliary target object 90B changes. The times when the contact state changes are respectively indicated in the example of Fig. 9 by "phase i (i = 1, 2, 3, ...)". Moreover, a second mark (solid line and black triangle in the phase display 63 of Fig. 9) is displayed on the phase display 63 at a position corresponding to the time being displayed on the time display 62. The time displayed on the time display 62 is specifiable by moving the second mark on the phase display 63. A third mark (dotted line in the phase display 63 of Fig. 9) illustrating a user recorded position and orientation, described later, is displayed on the phase display 63 at a position corresponding a time subject to a user recorded position and orientation.

The first presentation screen 60 also includes a record button 64. A user specifies a given time, the position and orientation of the main target object 90A and the auxiliary target object 90B at this time are displayed on the three-dimensional view 61, and the user corrects the position and orientation of the main target object 90A using a mouse operation or the like, before then selecting the record button 64. The position and orientation of the main target object 90A as corrected by the user are recorded for the time specified on the operation path. This recording is called "user recorded position and orientation". The first presentation screen 60 also includes a regeneration button 65. In cases in which the position and orientation has been recorded by the user on the operation path and the regeneration button 65 has been selected by the user, the display control section 38 receives the user recorded position and orientation, passes the received user recorded position and orientation to the generation section 36, and instructs regeneration of the operation path.

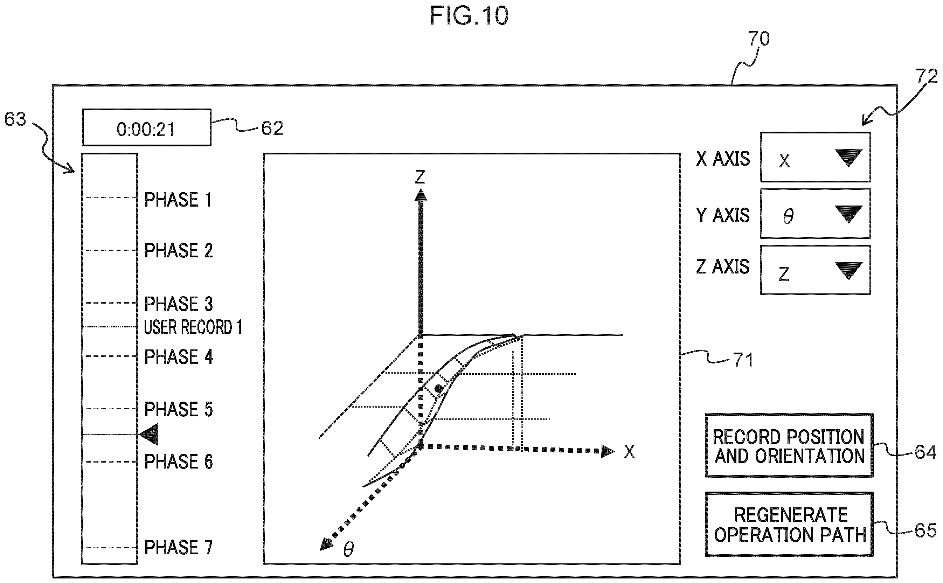

The display control section 38 also displays a second presentation screen 70 on the display device, for example as illustrated in Fig. 10. In the example of Fig. 10, the second presentation screen 70 includes a time display 62, a phase display 63, a record button 64, and a regeneration button 65, similarly to in the first presentation screen 60. Moreover, the second presentation screen 70 also includes a three-dimensional view 71. The three-dimensional view 71 is displayed with a configuration space in which three variables selected from among three degrees of freedom of position (X, Y, Z) and the three degrees of freedom of orientation (ϕ, θ, ψ) are displayed on three axes. Similarly to the three-dimensional view 61 of the first presentation screen 60, position and orientation can also be recorded by a user on the three-dimensional view 71. A user is able to correct the position and orientation of the main target object 90A by moving a coordinate point (the black point in the three-dimensional view 71 of Fig. 10) in the configuration space being displayed in the three-dimensional view 71. The second presentation screen 70 also includes a selection region 72 for selecting the three variables that are to be associated with the axes of the configuration space for display on the three-dimensional view 71.

The display control section 38 may display the first presentation screen 60 and the second presentation screen 70 on the display device in different respective windows at the same time as each other. The display control section 38 may display second presentation screens 70 for different selections of three variables on plural respective separate windows at the same time. In cases in which the first presentation screen 60 and the second presentation screen 70 are displayed in plural windows, the display control section 38 may synchronize the time displays 62 of the first presentation screen 60 and the second presentation screen 70 corresponding to each window, so as to interlock the displays of each window.

Next, description follows regarding operation of the robot control system 1 according to the present exemplary embodiment.

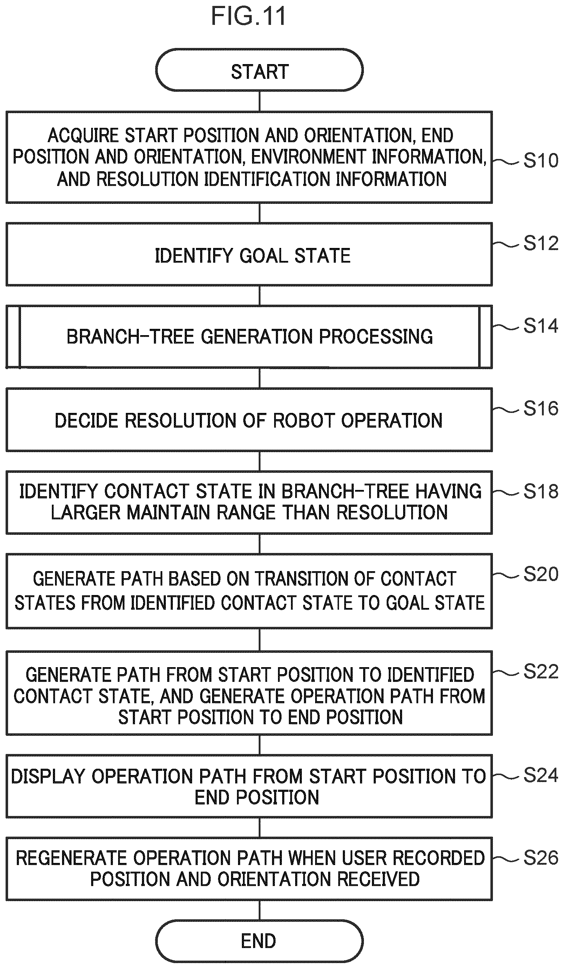

Fig. 11 is a flowchart illustrating a flow of the operation path generation processing execute by the CPU 12 of the operation path generation device 10. The CPU 12 functions as each functional configuration of the operation path generation device 10, and the operation path generation processing illustrated in Fig. 11 is executed, by the CPU 12 reading the operation path generation program from the storage device 16 and expanding and executing the operation path generation program in the memory 14.

At step S10, the acquisition section 32 acquires a start position and orientation, an end position and orientation, environment information, and resolution identification information that have been input to the operation path generation device 10.

Next, at step S12 the simulation section 34 identifies a goal state when the main target object 90A and the auxiliary target object 90B have been assembled based on the end position and orientation and the environment information acquired at step S10. Specifically, the simulation section 34 identifies a state of face contact with the greatest number of faces as the goal state from among assembled states of the main target object 90A and the auxiliary target object 90B at the end position and orientation. Note that the simulation section 34 identifies a state having the greatest number of edge contacts as the goal state in cases in which there is not even one face of face contact. In cases in which there are plural candidates for the goal state, any of these states may be identified as the goal state.

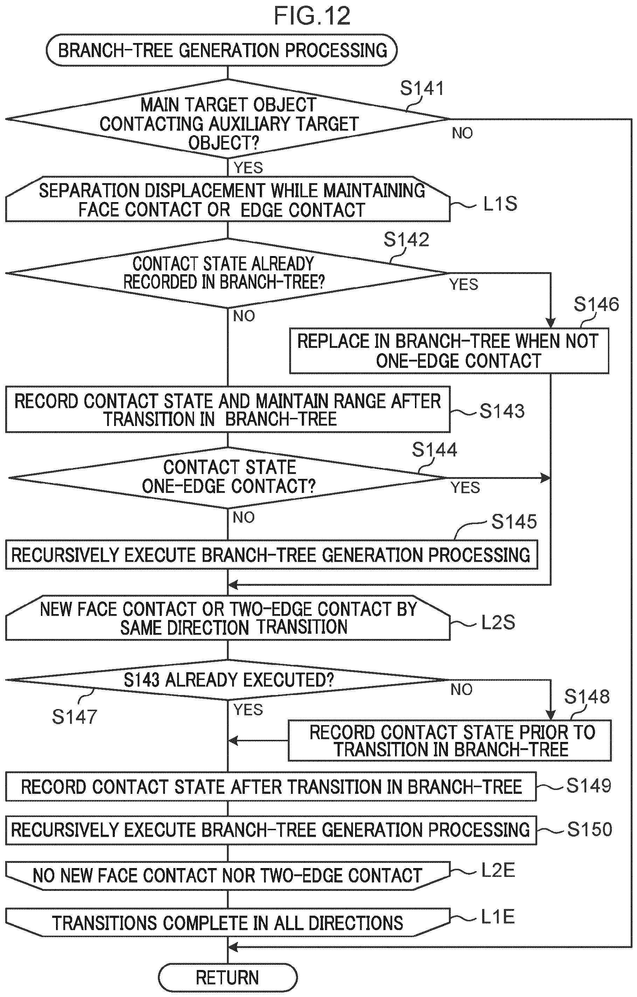

Next, at step S14, the simulation section 34 executes branch-tree generation processing. The branch-tree generation processing will now be described with reference to Fig. 12.

At step S141, the simulation section 34 determines whether or not the main target object 90A is contacting the auxiliary target object 90B. Processing transitions to loop processing L1 when there is contact therebetween, and the branch-tree generation processing is ended and returned when there is no contact therebetween.

The loop processing L1 starts at step L1S, and steps S142 to S 145 and loop processing L2 are executed for the transition of contact states (hereafter referred to as "L1 transition") from the current contact state in a direction (including a rotation) that both maintains face contact or edge contact and results in a separation displacement. The loop processing L1 is ended at step L1E when there are no longer any possible transition directions for the current contact state, except for directions that have already been found.

At step S142, the simulation section 34 determines whether or not the contact state after the L1 transition has already been recorded in the branch-tree. Processing transitions to step S146 when already recorded, and processing transitions to step S143 when not yet recorded. At step S143, the simulation section 34 finds a maintain range of the contact state after the L1 transition. The simulation section 34 records the contact state after the L1 transition and the maintain range thereof by recording in association with a node in the branch-tree connected downstream of the node corresponding to the contact state prior to the L1 transition.

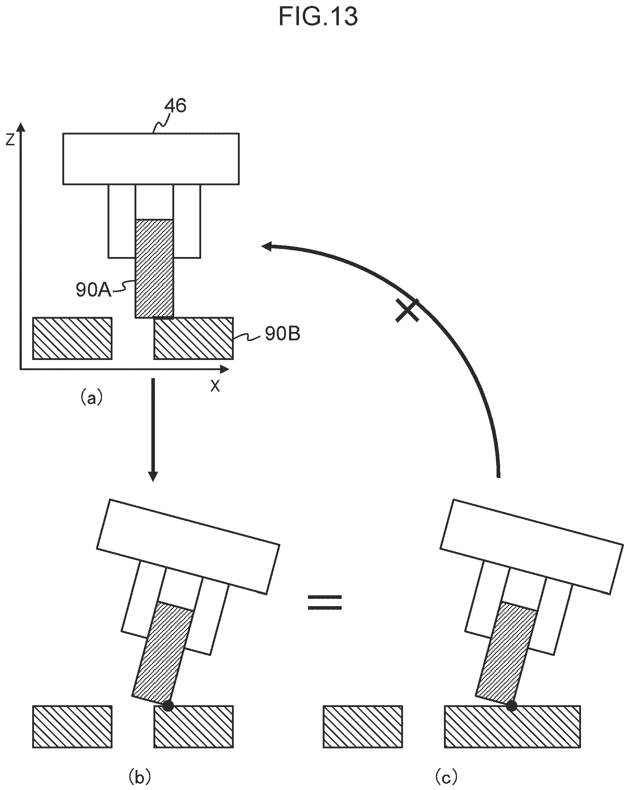

In order to find the maintain range of the contact state after the L1 transition, the simulation section 34 limits the maintain range to a range where it is possible to return to the same contact state as that prior to the L1 transition when a transition in a direction to return along the L1 transition has been executed. For example, as illustrated in Fig. 13(a), the contact state prior to the L1 transition is face contact in which part of the lower side Z face of the main target object 90A contacts the auxiliary target object 90B. As illustrated at (b), the contact state is transitioned from this state by rotating the main target object 90A while maintaining one-edge contact between the lower side Z face right (= right side X face bottom) of the main target object 90A and the upper side Z face of the auxiliary target object 90B. Suppose that, from the contact state after the L1 transition, the main target object 90A is translated in the X axis direction as illustrated at (c) as a maintain displacement. This a case of maintain displacement, however face contact in which the entire face of the lower side Z face of the main target object 90A contacts the auxiliary target object 90B would result from the rotation of the L1 transition being reversed from the state of (c), leading to a different contact state to that of (a). This means that in this case the state of (c) is not contained in the maintain range of (b).

Next, at step S144 the simulation section 34 determines whether or not the contact state after the L1 transition is one-edge contact. Processing transitions to loop processing L2 when one-edge contact, and processing transitions to step S145 when not one-edge contact, namely when two or more edge contact or face contact. At step S145, the simulation section 34 recursively executes the branch-tree generation processing with the contact state after the L1 transition as the contact state of the start time of branch-tree generation processing.

At step S146, in cases in which the contact state after the L1 transition is not one-edge contact, the simulation section 34 takes the node(s) corresponding to the contact state(s) after the L1 transition already recorded in the branch-tree, and the node recorded this time, and uses a tree segment from the node further from the root node to leaf nodes to replace the node of the branch-tree nearer to the root node. Processing then transitions to loop processing L2. Note that the processing of the present step is skipped in cases in which the contact state after the L1 transition is one-edge contact.

The loop processing L2 starts at step L2S, and steps S147 to S150 are executed for each of the transitions of contact states (hereafter referred to as "L2 transitions") that result in a new face contact or two or more edge contact by a transition in the same direction. The loop processing L2 is ended at step L2E when a new face contact or two or more edge contact is no longer reached.

At step S147, the simulation section 34 determines whether or not step S143 has been executed for the contact state prior to the L2 transition. Processing transitions to step S149 when executed, and processing transitions to step S148 when not executed. At step S148, the contact state prior to the L2 transition and the maintain range thereof are recorded in the branch-tree similarly to in the processing of step S143, and processing transitions to step S149. At step S149, the simulation section 34 records the contact state after the L2 transition and the maintain range thereof in the branch-tree similarly to in the processing of step S143. Next, at step S150, the simulation section 34 recursively executes the branch-tree generation processing with the contact state after the L2 transition as the contact state at the start time of branch-tree generation processing.

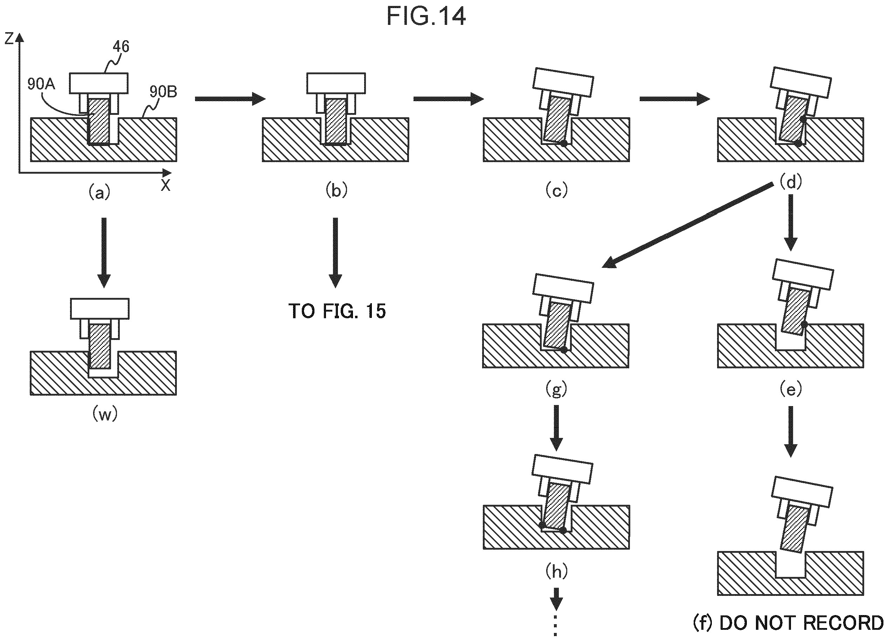

Detailed description follows regarding this branch-tree generation processing, using a specific example illustrated in Fig. 14 to Fig. 16. Note that Fig. 14 to Fig. 16 focus on transitions in the directions of X, Z, and θ and illustrate only contact states needed for explanatory purposes, with contact states considering transitions in other directions omitted in the drawings.

First, as illustrated in Fig. 14(a), the simulation section 34 identifies a state of face contact in which the two faces of the left side X face and the lower side Z face of the main target object 90A contact the auxiliary target object 90B as the goal state for starting the branch-tree generation processing. Next the simulation section 34 executes, as the L1 transition, for example a transition that translates the main target object 90A in the X axis direction while maintaining face contact with the lower side Z face. The contact state after the L1 transition for this case is illustrated in (b). The simulation section 34 records the contact state (b) in the branch-tree by connecting a node associated with the contact state (b) and the maintain range thereof to downstream of the root node corresponding to the goal state (step S143). The contact state (b) is not one-edge contact (negative determination at step S144), and the simulation section 34 executes the L1 transition from contact state (b) (loop processing L1 in step S145).

As the L1 transition from contact state (b) the simulation section 34 executes, for example, a transition to rotate the main target object 90A while maintaining one-edge contact at the lower side Z face right (right side X face bottom). The contact state after the L1 transition for this case is illustrated at (c). The simulation section 34 records the contact state (c) at a node downstream of the node corresponding to the contact state (b) (step S143). The contact state (c) is one-edge contact (affirmative determination at step S144), and so the loop processing L2 is executed. The two-edge contact state as illustrated at (d) results from the L2 transition continuing in the same direction as the transition from (b) to (c). Due to recording to the branch-tree already being performed for the contact state (c) prior to the L2 transition (affirmative determination at step S147), the simulation section 34 records the contact state (d) at a node downstream of the node corresponding to the contact state (c) (step S149). Next, the simulation section 34 executes the L1 transition from the contact state (d) (loop processing L1 in step S150).

A contact state a transition that translates the main target object 90A in the Z axis direction upward from the contact state (d) while maintaining one-edge contact at the right side X face of the main target object 90A has been executed as the L1 transition is illustrated at (e). The contact state (e) is one-edge contact (affirmative determination at step S144), and transition to loop processing L2, as illustrated at (f), does not give rise to new face contact or two-edge contact even when maintain displacement is performed in the same direction as the L1 transition. The simulation section 34 accordingly ends the loop processing L2, returns to the loop processing L1 of the path generation processing with the contact state (d) as the initial contact state, and executes the L1 transition in a direction different to the transition from (d) to (e).

A contact state after a transition that rotates the main target object 90A from the contact state (d) while maintaining one-edge contact at the lower side Z face right (= right side X face bottom) thereof has been executed as the L1 transition is illustrated at (g). The contact state (g) is similar to the contact state (c), is already recorded in the branch-tree (affirmative determination at step S142), and is one-edge contact, so step S146 is skipped and processing transitions to loop processing L2. When the L2 transition has been continued in the same direction as the L1 transition this results in two-edge contact such as illustrated at (h). The contact state (g) prior to the L2 transition has not passed through step S143 and so is not recorded in the branch-tree (negative determination at step S147). The simulation section 34, after recording the contact state (g) in the branch-tree (step S148), also records the contact state (h) in the branch-tree (step S149). Branch-tree generation processing similar to that described above (step S150 in step S150) is executed for the contact state (h) onwards.

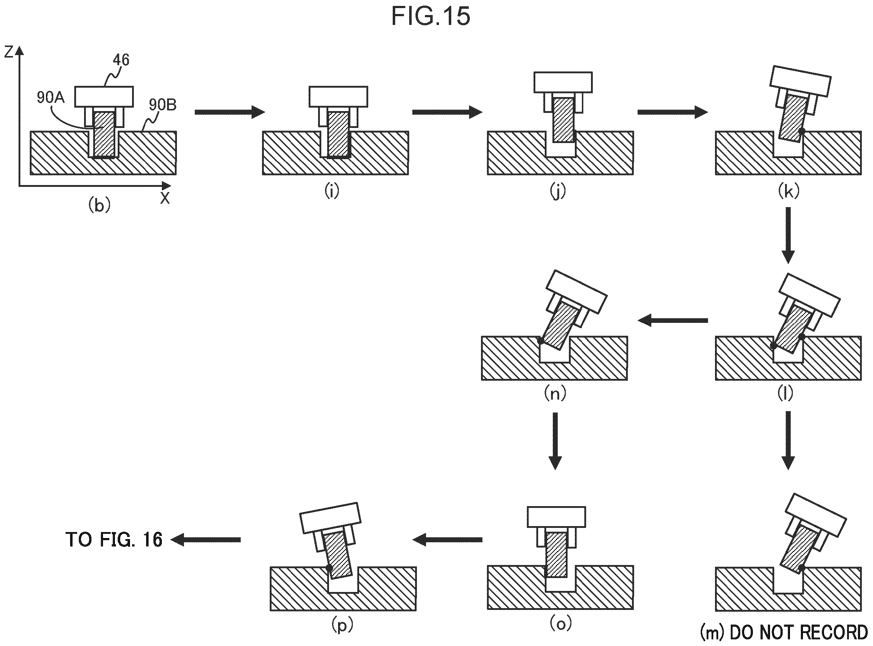

When the recursive execution of the branch-tree generation processing of step S145 has ended for the L1 transition from (a) to (b), the simulation section 34 executes the L2 transition in the same direction as the L1 transition from (a) to (b). In this case this results in, as illustrated in Fig. 15(i), a new face contact of contact at two faces of the lower side Z face and the right side X face. The simulation section 34 records the contact state (i) in the branch-tree (step S149), and recursively executes the branch-tree generation processing using the contact state (i) as the initial contact state (step S150).

A contact state after a transition that moves the main target object 90A in the Z axis upward from the contact state (i) while maintaining face contact at the right side X face has been executed as the L1 transition is illustrated at (j). The simulation section 34 records the contact state (j) in the branch-tree by connecting a node associated with the contact state (j) and the maintain range thereof (step S143). The contact state (j) is not a one-edge contact (negative determination at step S144), and so the simulation section 34 recursively executes the branch-tree generation processing using the contact state (j) as the initial contact state (step S145).

The contact state after a transition that rotates the main target object 90A from the contact state (j) while maintaining edge contact at the right side X face thereof has been executed as the L1 transition is illustrated at (k). The contact state (k) is similar to the contact state (e), is already recorded in the branch-tree (affirmative determination at step S142), and is one-edge contact, so step S146 is skipped and processing transitions to loop processing L2. A two-edge contact such as illustrated at (l) results from when the L2 transition has been continued in the same direction as the L1 transition. The contact state (k) prior to the L2 transition has not passed through the step S143, and so is not recorded in the branch-tree (negative determination at step S147). The simulation section 34, after recording the contact state (k) in the branch-tree (step S 148), also records the contact state (l) in the branch-tree (step S149). Branch-tree generation processing similar to as described above is executed for the contact state (k) (step S 150 in step S 150).

A contact state after a transition that translates the main target object 90A from the contact state (l) in the Z axis direction upward and in the X axis right direction while maintaining one-edge contact at the right side X face thereof has been executed as the L1 transition is illustrated at (m). The contact state (m) is the same as the contact state (e) and a new face contact or edge contact does not result even when the L2 transition is performed, and so the contact state (m) is not recorded in the branch-tree.

Moreover, a contact state after a transition that rotates the main target object 90A from the contact state (l) while maintaining one-edge contact at the left side X face thereof has been executed as the L1 transition is illustrated at (n). The simulation section 34 records the contact state (n) in the branch-tree (step S143) and transitions to the loop processing L2. Then a new face contact such as illustrated at (o) results when the L2 transition has been continued in the same direction as the L1 transition. The simulation section 34 records the contact state (o) in the branch-tree (step S149), and recursively executes the branch-tree generation processing using the contact state (o) as the initial contact state (step S 150).

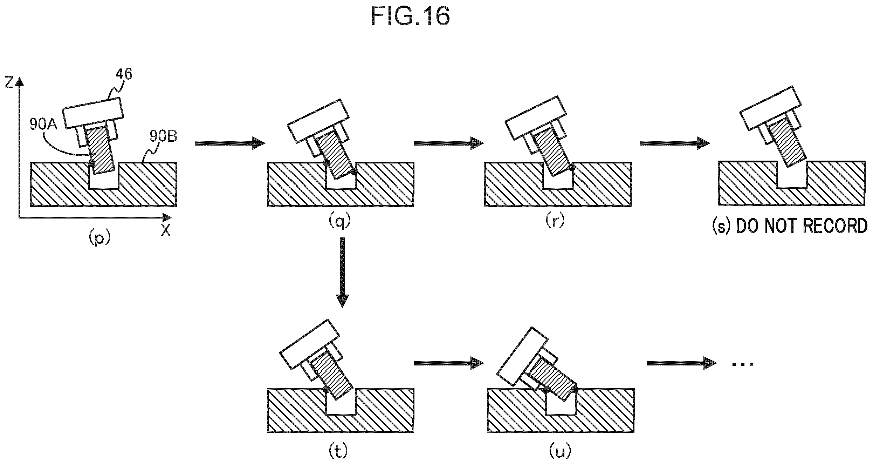

A contact state after a transition that rotates the main target object 90A from the contact state (o) while maintaining one-edge contact at the left side X face thereof has been executed as the L1 transition is illustrated at (p). The simulation section 34 records the contact state (p) in the branch-tree (step S143) and transitions to the loop processing L2. Then a new two-edge contact such as illustrated at (q) of Fig. 16 results when the L2 transition has been continued in the same direction as the L1 transition. The simulation section 34 records the contact state (q) in the branch-tree (step S149), and recursively executes the branch-tree generation processing using the contact state (q) as the initial contact state (step S150).

A contact state after a transition that translates the main target object 90A from the contact state (q) in the Z axis direction upward while maintaining one-edge contact at the right side X face thereof has been executed as the L1 transition is illustrated at (r). The simulation section 34 records the contact state (r) in the branch-tree (step S143) and transitions to the loop processing L2. As illustrated at (s), a new face contact or edge contact does not result even when the L2 transition is performed from the contact state (r), and so no recording is made to the branch-tree.

Moreover, a contact state after a transition that translates the main target object 90A from the contact state (q) to the X axis left side and Z axis upward while maintaining one-edge contact at the left side X face thereof has been executed as the L1 transition is illustrated at (t). The contact state (t) is similar to the contact state (p), is already recorded in the branch-tree (affirmative determination at step S142), and is one-edge contact, so step S146 is skipped and processing transitions to loop processing L2. A new face contact or two-edge contact does not result when the L2 transition is performed in the same direction as the L1 transition, and a non-contact state results. The simulation section 34 accordingly ends the loop processing L2, returns to the loop processing L1 of the branch-tree generation processing using the contact state (q) as the initial contact state, and executes the L1 transition in a direction different to the transition from (q) to (t). A contact state after a transition that rotates from the contact state (p) while maintaining two-edge contact at the X face left side and the X face right side (Z face right side) has been executed as the L1 transition is illustrated at (u). The simulation section 34 records the contact state (p) in the branch-tree (step S143), and the simulation section 34 recursively executes the branch-tree generation processing using the contact state (u) as the initial contact state (step S145).

When recursive execution of the branch-tree generation processing from contact state (b) onward has been completed and a return made to the branch-tree generation processing from the contact state (a), namely from the goal state, the simulation section 34 executes a transition that translates the main target object 90A in the Z axis upward while maintaining face contact with the left side X face as the L1 transition. The contact state after the L1 transition in such cases is illustrated at (w) of Fig. 14. The contact state (w) is the same as the contact state (o) of Fig. 15. For the node of the contact state (w) that is a node nearer to the root node (contact state (a)) of the branch-tree, the simulation section 34 uses a tree segment from the node corresponding to the contact state (o) to the leaf nodes to replace the node of the contact state (w) (step S146).

By performing the processing described above, a branch-tree is generated that connects the nodes corresponding to each of the contact states, as illustrated in Fig. 14 to Fig. 16.

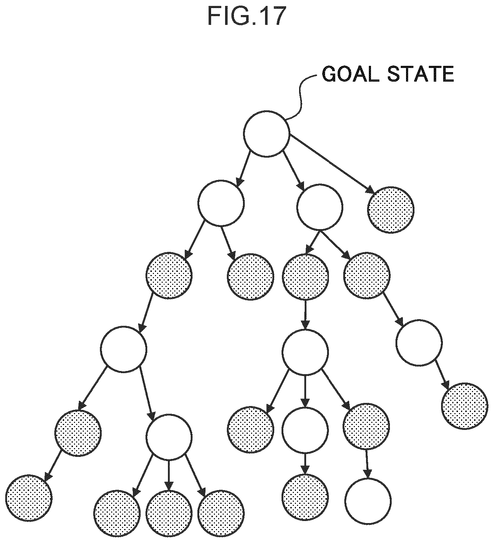

Description follows regarding the branch-tree generated by the above branch-tree generation processing, with reference to Fig. 17. In Fig. 17, the nodes corresponding to each of the contact states are illustrated by circles, and the L1 transition and the L2 transition are illustrated by arrows. Moreover, from among the nodes, nodes illustrated by a shaded circle are nodes corresponding to a one-edge contact state from among contact states found by searching (corresponding to each of the states (a) to (w) of Fig. 14 to Fig. 16). Moreover, nodes illustrated by a white circle are nodes corresponding to a two-edge contact, three-edge contact, or face contact state from among contact states found by searching.

As illustrated in Fig. 17, there is always a single state, not branching, for states transitioning from a one-edge contact state. Namely, branching only occurs at states corresponding to the white circle nodes in Fig. 17. However, sometimes states do not branch even at states corresponding to the white circle nodes. Generally, the leaf nodes (states with no further transitions, terminal ends) are one-edge contact states. However, there is a white circle node at a leaf node as long as this is a case in which state(s) corresponding to shaded nodes, which are ahead of the state corresponding to the white circle node, are already recorded in the branch-tree. There may be a transition from a one-edge contact state to a one-edge contact state. Moreover, there may be a transition from a two or more edge contact state (a state corresponding to a white circle node) to a two or more edge contact state.

Returning to the operation path generation processing (Fig. 11), at the next step S16, the generation section 36 decides a resolution of operation of the robot based on the resolution identification information acquired at step S10. Specifically, the generation section 36 takes resolutions in each direction (d = X, Y, Z, ϕ, θ, ψ) as being ε_{sdi} for the sensors, from among the sensors contained in the sensor group 50, that are capable of recognizing errors in the position and orientation of the main target object 90A and the auxiliary target object 90B for cases a non-contact state of the main target object 90A and the auxiliary target object 90B. i is used to represent an identification number appended to each sensor. The generation section 36 decides, for example, a resolution ε_{sdv} of a vision sensor having identification number v from a magnitude of possible feedback in robot control. More specifically, the generation section 36 may decide ε_{sdv} = (a length of a long edge of the main target object 90A) × 2/(number of pixels of a short side of the angle of view of the vision sensor) (d = X, Y). Here the vision sensor recognizable length is taken as being for cases in which the vision sensor is utilized such that the long edge of the main target object 90A is not more than half the short side of the angle of view of the vision sensor. The generation section 36 takes a resolution in a direction unrecognizable by the sensor as a maximum obtainable value, and finds ε_{sdi} as a six dimensional vector. The generation section 36 decides ε_{sd} = min (ε_{sdi}) as the resolution of the robot.

Next, at step S18, the generation section 36 identifies a contact state in the branch-tree having a larger maintain range than the resolution. For example, the generation section 36 identifies any nodes in the branch-tree that are associated with a maintain range capable of being contained in a region having one edge of ε_{sd}. A nearest node from the root node of the branch-tree is identified when there are plural such nodes present. The nearest node from the root node of the branch-tree may, for example, be a node having fewest nodes on the way from the root node, or may be a node nearest in terms of measured physical distance. The former has the merit of high control robustness, and the latter has the merit of short execution time. The former is adopted in the present exemplary embodiment. The generation section 36 identifies the contact state associated with the identified node.

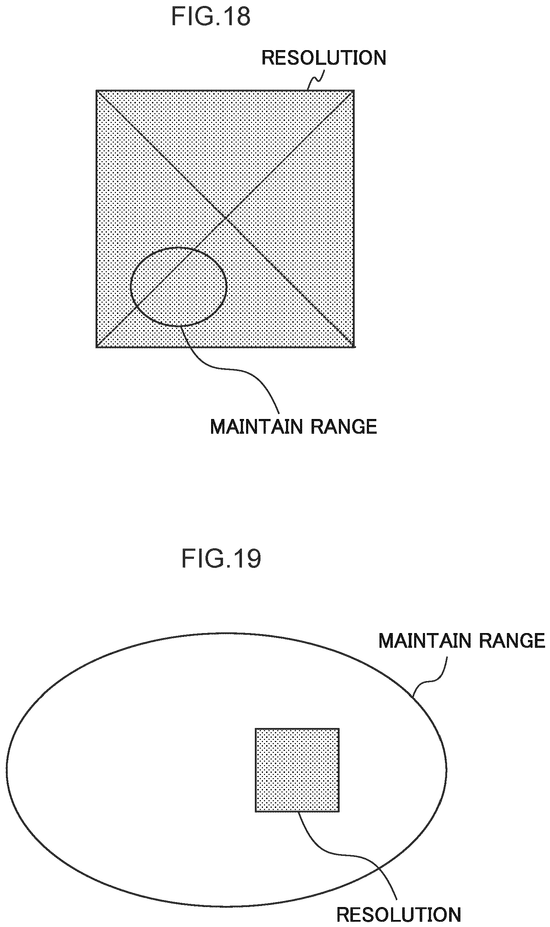

In cases in which the resolution is larger than the maintain range, sometimes there is a need to perform a probing operation to reach the identified contact state from a non-contact state. For example, in cases in which the robot 42 is controlled so as to move the main target object 90A gripped by the hand section 46 to a center position of resolution then, as illustrated in Fig. 18, this does not enable the maintain range of the identified contact state to be reached. However, as illustrated in Fig. 19, if the resolution is smaller than the maintain range, then maintain range of the identified contact state can be reliably reached from the non-contact state based on error in position and orientation recognizable by the sensor.

Next, at step S20, the generation section 36 generates an operation path based on a transition of contact states from the identified contact state to the goal state. Specifically, the generation section 36 generates a trace in the branch-tree from the identified contact state to the goal state by identifying and arranging the positions and orientations of the hand section 46 from the contact states corresponding to each of the nodes from the node corresponding to the contact state identified at step S 18 up to the root node.

Next, at step S22, the generation section 36 generates a path that leads from the start position and orientation acquired at step S10 to the position and orientation corresponding to the contact state identified at step S18, and that is also a path avoiding obstructions. Then the generation section 36 joins the path generated at step S20 together with the path generated at the present step so as to generate the operation path with the contact states associated with each of the positions and orientations.

Next, at step S24, the display control section 38 displays on the display device at least one from out of the first presentation screen 60 or the second presentation screen based on the operation path generated at step S22. The display control section 38 then receives a user recorded position and orientation that is a correction by the user to the position and orientation of the main target object 90A.

Next, at step S26, in cases in which a user recorded position and orientation has been received at step S24, the generation section 36 regenerates the operation path so as to reflect in the operation path generated at step S24 the user recorded position and orientation that has been received. The generation section 36 then outputs the finally generated operation path to the robot control device 40, and ends the operation path generation processing.

The robot control device 40 generates command values for force control to implement the operation path input from the operation path generation device 10, and outputs these to the robot 42.

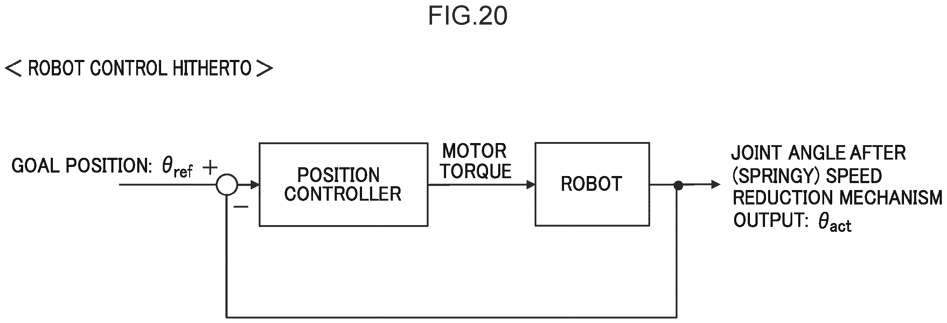

In robot control hitherto that does not consider contact between the main target object 90A and the environment, as illustrated in Fig. 20, from a goal position θ_{ref} based on the operation path, motor torque to implement this goal position θ_{ref} is computed by a position controller, and the robot is controlled thereby. A joint angle θ_{act} after (springy) speed reduction mechanism output is acquired from the robot that is being controlled, and the actual joint angle θ_{act} is fed back to the position controller.

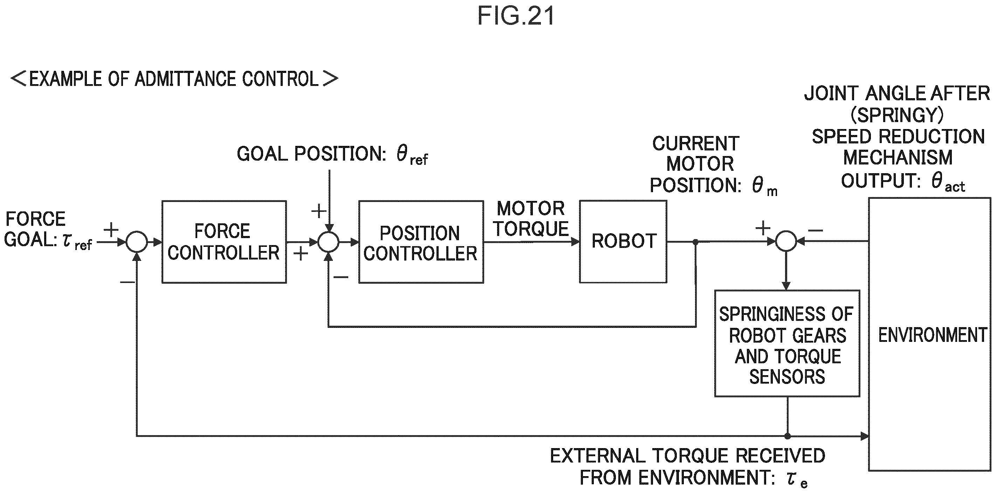

Fig. 21 illustrates admittance control as an example of an implementation example of a force control system as the target for implementation of the present disclosure. This example includes a goal position θ_{ref} specified by a user added to a corrected value produced by a force controller correcting a value resulting from subtracting an external torque τₑ received from the environment from a force goal τ_{ref} according to the operation path, and a position goal value is computed by subtracting a current position θₘ of the motor therefrom. A motor torque to implement this position goal value is then computed by the position controller, and used to control the robot. The current position θₘ of the motor is then acquired from the robot being controlled, and fed back to the position controller. Moreover, a joint angle θ_{act} after (springy) speed reduction mechanism output is acquired based on contact between the robot and the environment, a value resulting from subtracting θ_{act} from θₘ is converted into an external torque τₑ received from the environment based on the springiness of the robot gears and torque sensors, and this difference value is fed back to the force controller.

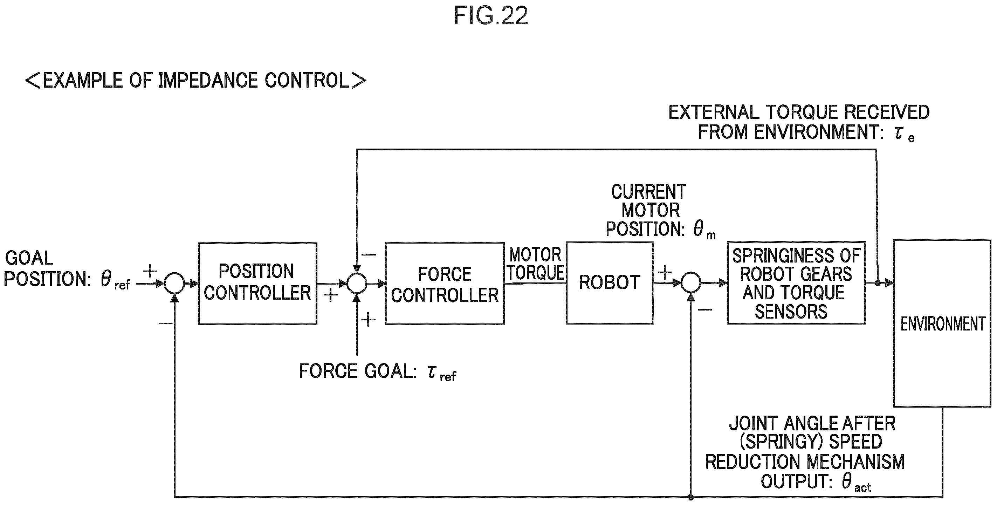

Moreover, Fig. 22 illustrates an example of impedance control as an example of an implementation example of a force control system as the target for implementation of the present disclosure. In such cases a force goal τ_{ref} specified by a user is added to a corrected value produced by a position controller correcting a value resulting from subtracting a joint angle θ_{act} after (springy) speed reduction mechanism output from a goal position θ_{ref} according to the operation path, and a force goal value is computed by subtracting an external torque τₑ received from the environment therefrom. The motor torque to implement this force goal value is computed by a force controller, and the robot is controlled thereby. The current position θₘ of the motor is then acquired from the robot being controlled, a value resulting from subtracting θ_{act} from θₘ is converted into the external torque τₑ received from the environment based on the springiness of the robot gears and torque sensors, and this difference value is fed back to the force controller. Moreover, the j oint angle θ_{act} after the (springy) speed reduction mechanism output is fed back to the position controller.

As described above, in the robot control system according to the present exemplary embodiment, for an operation to assemble a main target object gripped by a gripping section of a robot together with an auxiliary target object that is an assembly target, the operation path generation device acquires a start position and orientation and an end position and orientation of the gripping section relative to the main target object, and acquires shape information of a task environment containing the main target object and the auxiliary target object. Moreover based on the acquired information, the operation path generation device performs a simulation of a transition of contact states between the main target object and the auxiliary target object, from a contact state between the main target object and the auxiliary target object until there is a non-contact state between the main target object and the auxiliary target object. Then based on the acquired information and the transition of contact states that has been simulated, an operation path of the robot is generated to reach a goal state from an initial state, which is the start position and orientation of the main target object, until reaching one or other contact state included in the transition of contact states, along a transition of contact states including the one or other of the contact states. This thereby enables an operation path to be generated that can be executed at high speed without a probing operation, from among paths that exist for a task to assemble target objects together.

This thereby enables a task to be executed by the robot at high speed. Moreover, there is a dramatic reduction in teaching man hours due to the robot being able to execute the assembly operation both automatically and autonomously. Moreover, even if there is some position and orientation errors between the actual position and orientation and the control goal, the robot corrects the position and orientation autonomously, so as to enable task completion.

Note that although the above exemplary embodiment has been described for a case in which a state corresponding to an end position and orientation serves as the goal state, the position and orientation of an intermediate point may be set as the goal state when generating a branch-tree. In such cases, when the end position and orientation can be reached following the contact states from the intermediate point, a branch-tree to represent a transition of contact states including the state of the end position and orientation is generated. Note that in cases in which the end position and orientation is not included in the generated branch-tree, this indicates that the end position and orientation is unable to be reached from the specified intermediate point.

Note that although the above exemplary embodiment has been described for a case in which the operation path generation device and the robot control device are separate devices, a configuration may be adopted in which the operation path generation device is incorporated in the robot control device. Moreover, the operation path generation processing may be implemented by distributed processing, with each of the functional configuration of the operation path generation device implemented by different respective devices.

Moreover, the operation path generation processing executed by the CPU reading software (a program) in the above exemplary embodiment may be executed by various processors other than a CPU. Examples of such processors include programmable logic devices (PLD) that allow circuit configuration to be modified post-manufacture, such as field-programmable gate arrays (FPGA), and dedicated electronic circuits, these being processors including a circuit configuration custom-designed to execute specific processing, such as an application specific integrated circuits (ASIC). Moreover, the operation path generation processing may be executed by any one of these various types of processor, or may be executed by a combination of two or more of the same type or different types of processor (such as plural FPGAs, or a combination of a CPU and an FPGA). The hardware structure of these various types of processors is more specifically an electronic circuit combining circuit elements such as semiconductor elements.

Moreover, although in the above exemplary embodiment an embodiment was described in which the operation path generation program was pre-stored (installed) on a storage device, there is no limitation thereto. The program may be provided in a format stored on a storage medium such as a CD-ROM, a DVD-ROM, a Bluray disc, USB memory, or the like. The program may also be provided in a format downloadable from an external device over a network.

### Explanation of the Reference Numerals

- 1: robot control system

- 10: operation path generation device
- 12: CPU
- 14: memory
- 16: storage device
- 18: input device
- 20: output device
- 22: storage medium reading device
- 24: communication I/F
- 26: bus
- 32: acquisition section
- 34: simulation section
- 36: generation section
- 38: display control section
- 40: robot control device
- 42: robot
- 44: robot arm
- 46: hand section
- 50: sensor group
- 60: first presentation screen
- 70: second presentation screen
- 90A: main target object
- 90B: auxiliary target object

## Claims

1. An operation path generation device, comprising:
an acquisition section that, for an operation to assemble a main target object gripped by a gripping section of a robot together with an auxiliary target object that is an assembly target, acquires a start position and orientation, and an end position and orientation, of the gripping section relative to the main target object, and acquires shape information of a task environment containing the main target object and the auxiliary target object;
a simulation section that, based on the information acquired by the acquisition section, performs a simulation of a transition of contact states between the main target object and the auxiliary target object, from a contact state between the main target object and the auxiliary target object until there is a non-contact state between the main target object and the auxiliary target object; and
a generation section that, based on the information acquired by the acquisition section and on the transition of contact states simulated by the simulation section, generates an operation path of the robot to reach a goal state from an initial state, which is the start position and orientation of the gripping section, until reaching one or another contact state included in the transition of contact states, along a transition of contact states including the one or the other of the contact states.

2. The operation path generation device of claim 1, wherein the simulation section includes searching for transitions of contact states from the goal state by repeatedly performing a simulation in which, in a case in which the contact state between the main target object and the auxiliary target object reaches a non-movement state even though force is applied in a first direction and has reached a non-movement state when force continues to be applied in a second direction different to the first direction, force continues to be applied from the non-movement state in a direction different to the first direction and the second direction.

3. The operation path generation device of claim 2, wherein the simulation section generates a branch-tree having the goal state as a root node and having respective different contact states as nodes, while sequentially searching for the transitions of contact states.

4. The operation path generation device of claim 3, wherein the simulation section associates each of the nodes of the branch-tree with a maintain range in which the main target object is able to displace while a contact state associated with the node is maintained.

5. The operation path generation device of claim 4, wherein:
the acquisition section acquires information to identify a resolution of operation of the robot; and
the generation section identifies, as the one or the other of the contact states, a contact state that is associated with a node in the branch-tree for which the associated maintain range is larger than the resolution.

6. The operation path generation device of claim 5, wherein in a case in which a plurality of the one or the other of the contact states have been identified, the generation section identifies a contact state associated with a node nearest from the root node of the branch-tree as the one or the other of the contact states.

7. The operation path generation device of claim 5, wherein the information to identify the resolution of operation of the robot includes at least one of a resolution of a sensor to detect the task environment or a control precision of an actuator to drive the robot.

8. The operation path generation device of any one of claim 1 to claim 7, further comprising a display control section that displays the operation path generated by the generation section at a display device.

9. The operation path generation device of claim 8, wherein:
the display control section receives a correction from a user to the operation path being displayed; and
the generation section regenerates the operation path based on the received correction.

10. The operation path generation device of any one of claim 1 to claim 7, wherein the robot is a soft robot including a soft structure that is outpushed by reaction force from contact with an external environment.

11. An operation path generation method, comprising:
an acquisition section acquiring, for an operation to assemble a main target object gripped by a gripping section of a robot together with an auxiliary target object that is an assembly target, a start position and orientation, and an end position and orientation, of the gripping section relative to the main target object, and acquiring shape information of a task environment containing the main target object and the auxiliary target object;
a simulation section performing a simulation, based on the information acquired by the acquisition section, of a transition of contact states between the main target object and the auxiliary target object, from a contact state between the main target object and the auxiliary target object until there is a non-contact state between the main target object and the auxiliary target object; and
a generation section generating, based on the information acquired by the acquisition section and on the transition of contact states simulated by the simulation section, an operation path of the robot to reach a goal state from an initial state, which is the start position and orientation of the gripping section, until reaching one or another contact state included in the transition of contact states, along a transition of contact states including the one or the other of the contact states.

12. An operation path generation program that causes a computer to function as:
an acquisition section that, for an operation to assemble a main target object gripped by a gripping section of a robot together with an auxiliary target object that is an assembly target, acquires a start position and orientation, and an end position and orientation, of the gripping section relative to the main target object, and acquires shape information of a task environment containing the main target object and the auxiliary target object;
a simulation section that, based on the information acquired by the acquisition section, performs a simulation of a transition of contact states between the main target object and the auxiliary target object, from a contact state between the main target object and the auxiliary target object until there is a non-contact state between the main target object and the auxiliary target object; and
a generation section that, based on the information acquired by the acquisition section and on the transition of contact states simulated by the simulation section, generates an operation path of the robot to reach a goal state from an initial state, which is the start position and orientation of the gripping section, until reaching one or another contact state included in the transition of contact states, along a transition of contact states including the one or the other of the contact states.
